Europäisches Patentamt

European Patent Office

Office européen des brevets

(11) Numéro de publication: **0 287 010 B1**

## (12) FASCICULE DE BREVET EUROPEEN

(45) Date de publication de fascicule du brevet: **20.05.92**  (51) Int. Cl.⁵: **H03B 5/18**

(21) Numéro de dépôt: **88105715.2**

(22) Date de dépôt: **11.04.88**

(54) **Oscillateur à resonateur diélectrique et accord électronique de fréquence par varactor, notamment dans la gamme des 22 GHz.**

(30) Priorité: **15.04.87 FR 8705359**

(43) Date de publication de la demande:
**19.10.88 Bulletin  88/42**

(45) Mention de la délivrance du brevet:
**20.05.92 Bulletin  92/21**

(84) Etats contractants désignés:
**DE FR GB IT NL SE**

(56) Documents cités:
**EP-A- 0 137 281**
**FR-A- 2 438 937**
**US-A- 4 477 788**
**US-A- 4 618 836**

**PATENT ABSTRACTS OF JAPAN, vol. 5, no.
40 (E-49)[712], 17 mars 1981, page 15 E 49; &
JP-A-55 162 634 (SONY K.K.) 18-12-1980**

(73) Titulaire: **ALCATEL TELSPACE**
**5, rue Noel Pons**
**F-92734 Nanterre Cédex(FR)**

(72) Inventeur: **Mettoudi, Isaac**
**22, rue de Lorraine**
**F-92300 Levallois Perret(FR)**

(74) Mandataire: **Weinmiller, Jürgen et al**
**Lennéstrasse 9 Postfach 24**
**W-8133 Feldafing(DE)**

# Description

L'invention se rapporte à un oscillateur à résonateur diélectrique et accord électronique de fréquence par varactor, notamment dans la gamme des 22 GHz (par exemple de 18 GHz à 24 GHz).

La nouvelle génération des faisceaux Hertziens et des relais mobiles opérant dans la gamme des 22 GHz, nécessite de plus en plus l'utilisation de sources hyperfréquence de haute stabilité, de faible consommation et de faible coût capables d'être également accordables électroniquement en fréquence.

Les moyens employés dans la technologie antérieure consistaient à utiliser un composant à l'état solide, tel qu'un transistor à effet de champ (FET. As Ga) stabilisé grâce à un résonateur diélectrique, le moyen utilisé pour ajuster la fréquence de l'oscillateur consistant à déplacer un disque juste au-dessus du résonateur.

Or, lorsqu'on travaille aux environs de 22 GHz ou au-delà, il est nécessaire d'utiliser des puces de transistor FET AsGa. Pour éviter que ces puces ne se détériorent dans le temps il est nécessaire de faire le vide et d'introduire un gaz neutre à l'intérieur du boîtier. On comprend aisément que tout réglage mécanique devient alors pratiquement impossible lorsque l'oscillateur est monté sur le matériel, d'autant plus lorsque la fréquence de l'oscillateur varie dans le temps, d'où la nécessité d'utiliser un oscillateur à transistor et à résonateur diélectrique, accordable en fréquence à l'aide d'un varactor.

En effet, lorsqu'on souhaite faire varier la fréquence d'un oscillateur à transistor et à résonateur diélectrique, ou pouvoir moduler ces oscillateur, un moyen utilisé consiste à coupler une ligne microruban à une ligne principale et à insérer une varactor dans la ligne couplée ; Le résonateur diélectrique pouvant être placé entre les deux lignes.

Dans une telle technologie, le réglage du résonateur diélectrique sert à la fois :
- à coupler la ligne microruban contenant le varactor, à la ligne microruban principale ;
- à déterminer la fréquence de l'oscillateur ;
- à obtenir la puissance de sortie optimale de l'oscillateur voir par exemple US-A-4 618 836.

Mais lorsqu'on travaille à des fréquences élevées, de l'ordre de 22 GHz par exemple, un oscillateur de ce type devient très critique à mettre en oeuvre et particulièrement délicat à régler en production de série.

La présente invention a pour objet de pallier de tels inconvénients.

L'invention propose à cet effet un oscillateur à résonateur diélectrique et accord électronique de fréquence par varactor, notamment dans la gamme des 22 GHz, comprenant un élément électronique actif à résistance négative, au moins deux résonateurs diélectriques, et un substrat à la surface duquel sont disposés trois pistes microruban, à la première et à la seconde pistes, qui sont situées dans le prolongement l'une de l'autre, étant connectées respectivement deux électrodes de l'élément actif, caractérisé en ce qu'à la troisième piste de direction parallèle aux deux première est connecté le varactor, les résonateurs diélectriques étant couplés à la première piste microruban.

Avantageusement la première et la troisième piste ont une première extrémité couplée respectivement à deux charges 50 Ω, la seconde piste ayant une première extrémité couplée à une quatrième ligne reliée à une fiche de sortie hyperfréquence. L'élément électronique actif à résistance négative est un transistor FET ayant deux de ses électrodes, grille et drain, reliées respectivement aux secondes extrémités de la première et de la seconde lignes. Ce transistor a ses autres électrodes soudées sur un petit support situé dans une ouverture oblongue réalisée dans le substrat.

Dans une première variante de réalisation, l'oscillateur de l'invention comprend deux résonateurs diélectriques respectivement situés de part et d'autre de la première piste microruban.

Le fait d'utiliser deux résonateurs diélectriques permet de séparer les fonctions de couplage et de réglage en fréquence et permet donc un réglage bien plus souple et plus aisé que dans les montages utilisant un seul résonateur diélectrique.

Dans une seconde variante de réalisation l'oscillateur de l'invention comprend trois résonateurs diélectriques disposés entre la première et la troisième pistes microruban.

Une telle réalisation permet d'une part d'obtenir un excellent couplage entre la première et la troisième ligne microruban, et d'autre part d'améliorer le temps de réglage de l'oscillateur.

Dans une forme de réalisation particulièrement avantageuse l'oscillateur de l'invention se compose principalement d'un boîtier sur lequel vient se souder le substrat, le transistor en puce étant soudé sur un support, par exemple en cuivre lui-même soudé sur la masse même du boîtier. La polarisation du transistor s'effectue à travers des traversées étanches de grille et de drain. La troisième ligne microruban sur laquelle est fixée un varactor est couplée à la piste de grille, grâce aux trois résonateurs diélectriques, qui servent également à déterminer la fréquence de sortie de l'oscillateur. Aus dessus du boîtier se trouve un couvercle dans lequel se trouve un trou taraudé qui constitue une cheminée. Dans ce trou taraudé vient se visser une vis à double filetage à l'intérieur de laquelle est disposée une vis autoserrante et ajustable.

Les caractéristiques et avantages de l'invention ressortiront d'ailleurs de la description qui va suivre, à titre non limitatif, en référence aux figures annexées sur lesquelles :

- la figure 1 illustre le schéma partiel d'un oscillateur selon l'invention ;
- la figure 2 illustre le schéma partiel d'une variante de l'oscillateur selon l'invention ;
- la figure 3 illustre une vue en coupe de l'oscillateur représenté à la figure 2 installé dans son boîtier ;
- la figure 4 illustre une vue partielle de dessus avec arrachement partiel de l'oscillateur installé dans son boîtier tel que représenté à la figure 3.

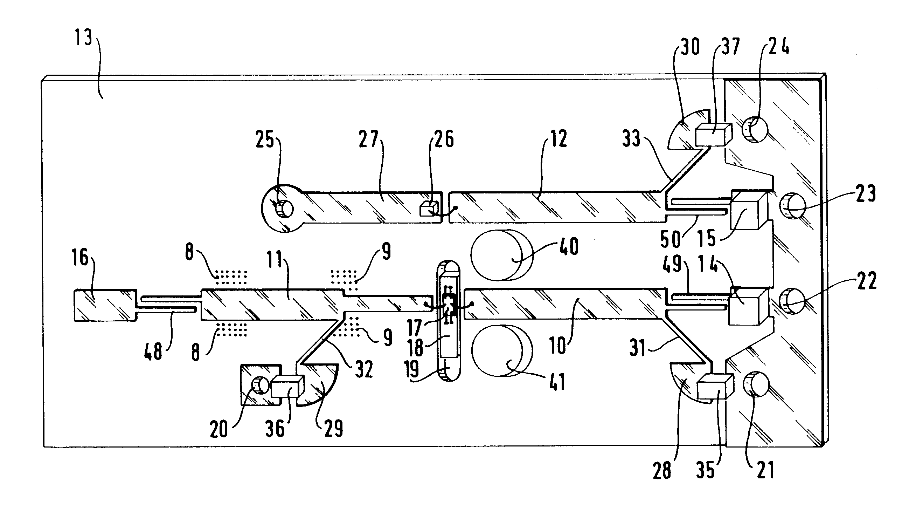

L'oscillateur, tel que représenté à la figure 1, comprend trois pistes microruban 10, 11, 12 disposées à la surface d'un substrat 13 ; les deux premières 10 et 11 étant dans le prolongement l'une de l'autre et la troisième 12 leur étant parallèle.

La première 10 et la troisième 12 piste ont une première extrémité couplée respectivement à deux charges 50 Ω 14 et 15, la seconde ayant une première extrémité couplée à une quatrième ligne 16 reliée à une fiche de sortie hyperfréquence, non représentée sur la figure.

Un élément électronique actif à résistance négative 17, par exemple un transistor FET AsGa, a deux de ses électrodes, grille et drain, reliées respectivement aux secondes extrémités de la première 10 et de la seconde ligne 11. Ce transistor 17 a ses autres électrodes soudées sur un petit support 18 situé dans une ouverture 19 oblongue réalisée dans le substrat 13.

Les trous 20, 21, 22, 23, 24 et 25 sont des trous métallisés qui permettent une liaison au plan de masse situé sur l'autre face du substrat.

Une diode 26 à capacité variable, ou varactor, est reliée d'une part à la seconde extrémité de la troisième piste 12 et d'autre part à la masse via un élément de piste 27 et le trou métallisé 25.

Trois circuits de polarisation, chacun formé d'une ligne basse impédance (28, 29, 30) en quart de cercle et d'une ligne forte impédance 31, 32, 33) rendant l'influence de ces circuits négligeable aux fréquences de travail, permettent respectivement de réaliser :

- la polarisation de grille (lignes 28 et 31) ;
- la polarisation de drain (lignes 29 et 32) ;
- la polarisation du varactor (lignes 30 et 33).

Des capacités de découplage (35, 36 et 37) sont connectées entre les lignes basse impédance (28, 29, 30) et les trous métallisés (21, 20, 24).

Deux résonateurs diélectriques 40 et 41 sont situés de part et d'autre de la première ligne microruban 10 reliée à la grille du transistor 17.

Les zones 8 et 9 de réglage d'impédance, réalisées par dépôt de laque d'argent permettent de réaliser des stubs d'accord en deux endroits différents de la seconde ligne microruban 11.

Dans cette configuration représentée à la figure 1, le premier résonateur diélectrique 40, situé entre la première ligne microruban 10 reliée à la grille du transistor à effet de champ 17 et la troisième ligne microruban 12 contenant le varactor 26, permet de coupler convenablement le varactor 26 au transistor 17.

Le deuxième résonateur diélectrique 41 situé de l'autre côté de la première ligne microruban 10 reliée à la grille du transistor 17 permet d'ajuster de manière convenable la fréquence de sortie de l'oscillateur.

Le fait d'utiliser deux résonateurs diélectriques 40 et 41 et de séparer en quelque sorte les fonctions de couplage et de réglage en fréquence, permet un réglage bien plus souple et plus aisé que dans les montages utilisant un seul résonateur diélectrique. En effet, en jouant sur la hauteur H du second résonateur diélectrique 41 on peut augmenter ou diminuer la fréquence de sortie sans avoir à retoucher le premier résonateur 40 ; La fréquence de résonance d'un résonateur augmentant, en effet, lorsque sa hauteur diminue.

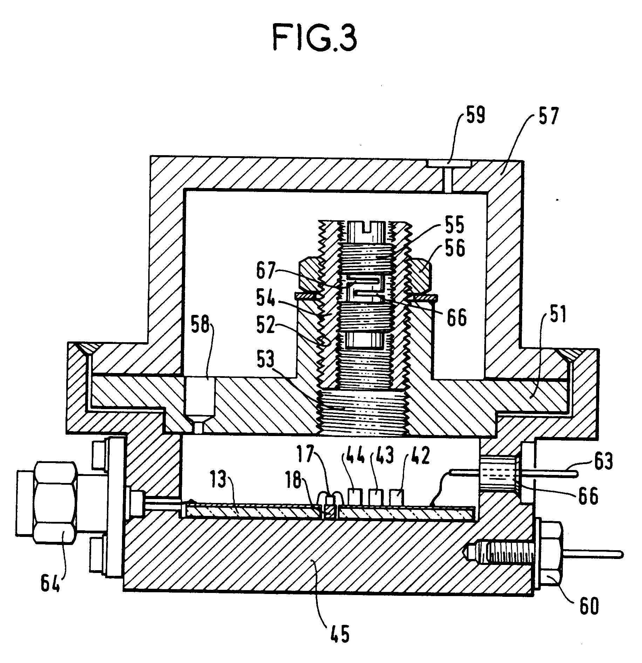

Un réglage complémentaire de la fréquence de l'oscillateur peut être effectué en utilisant le dispositif à cheminée tel que représenté à la figure 3, qui sera décrit ultérieurement.

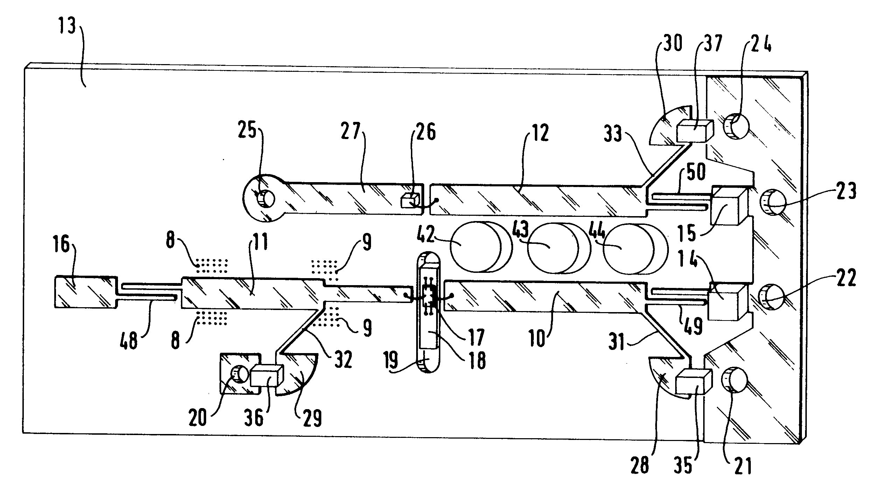

Une variante de réalisation de l'invention, permettant une très grande souplesse de réglage et un excellent couplage du varactor, dans la bande des 22 Gigahertz, par exemple, consiste à utiliser l'oscillateur représenté aux figures 2, 3 et 4.

Cette configuration se différentie de celle représentée à la figure 1, en ce qu'elle utilise trois résonateurs 42, 43 et 44.

Ces trois résonateurs diélectriques 42, 43 et 44 sont de même diamètre et de même hauteur et permettent de déterminer la fréquence de l'oscillateur.

Ces trois résonateurs diélectriques sont couplés entre eux et permettent également de coupler la troisième piste microruban 12 contenant le varactor à la première ligne microruban 10 reliée à la grille du transistor 17.

Un réglage complémentaire de la fréquence de l'oscillateur peut être effectué en utilisant le dispositif à cheminée représenté à la figure 3.

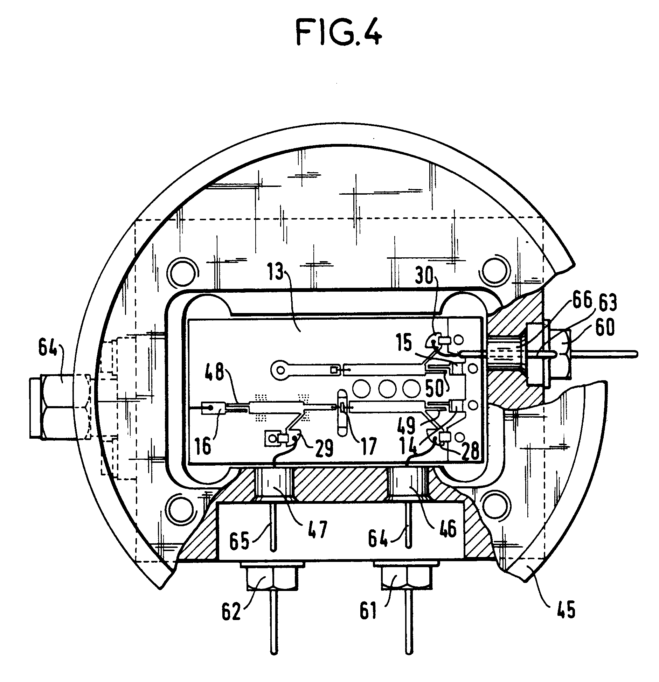

L'oscillateur, représenté aux figures 3 et 4, à résonateur diélectrique et à varactor se compose principalement d'un boîtier 45 en DILVER par exemple, sur lequel vient se souder le substrat 13, qui est par exemple une plaquette de quartz. Le DILVER et le quartz présentent, en effet, des coefficients de dilatation compatibles.

Une ouverture oblongue 19 est creusée dans le substrat quartz. Le transistor FET AsGa en puce est soudé sur le support 18, par exemple en cuivre, situé dans cette ouverture 19. Ce support est lui-même soudé sur la masse même du boîtier 45 ; Ceci afin d'assurer une bonne dissipation thermique pour le transistor 17.

Le transistor 17 est monté, par exemple, en source commune. Le drain est alors relié à la seconde piste microruban 11 "de drain". La grille est reliée à la première ligne microruban 10 "de grille". La polarisation du transistor s'effectue à travers des traversées étanches de grille 46 et de drain 47. La troisième ligne microruban 12, sur laquelle est fixée le varactor 26, est couplée à la piste de grille, grâce aux trois résonateurs diélectriques 42, 43, 44 qui servent également à déterminer la fréquence de sortie de l'oscillateur. La polarisation du varactor 26 s'effectue à travers une traversée étanche 66.

Les pistes 10 et 12 de grille et de varactor sont terminées à une extrémité par les charges 50 $\Omega$. Les gaps 48, 49 et 50, constituant des coupures adaptées, qui permettent d'isoler le transistor 17 et le varactor 26 de ces charges 50 $\Omega$, 14 et 15.

Au dessus du boîtier 45 se trouve un couvercle 51, lui aussi par exemple en DILVER. Dans ce couvercle 51 est usiné un trou taraudé 52, qui constitue une cheminée 53. Dans ce trou taraudé 52 vient se visser une vis à double filetage 54 à l'intérieur de laquelle est disposée une vis autoserrante et ajustable 55 munie de deux encoches transversales 67 et 68. La vis 54 à double filetage est bloquée à l'aide d'un écrou de blocage 56.

Ce dispositif de cheminée constitue un moyen de régler la fréquence de sortie de l'oscillateur et permet un dégagement des lignes de champ audessus des résonateurs diélectriques 42, 43 et 44.

Après le réglage de l'oscillateur, un capot 57 est soudé au boîtier, par une soudure au laser par exemple, et l'étanchéité de l'ensemble est réalisé en faisant le vide et en injectant un gaz neutre à l'intérieur du boîtier. Le couvercle 51 et le capot 57 sont munis à cet effet, respectivement d'orifices 58 et 59.

Cette opération est effectuée pour protéger le transistor et permettre une meilleure tenue de l'oscillateur dans le temps.

Différentes fiches de sorties 60, 61, 62, 63, 64 et 65 sont représentées elles sont respectivement :
- trois picots de masse 60, 61 et 62 ;
- une fiche de polarisation varactor 63 reliée à la piste 30 ;
- une fiche de polarisation grille 64 reliée à la piste 28 ;
- une fiche de polarisation drain 65 reliée à la piste 29 ;
- et la fiche de sortie de l'oscillateur 64 reliée à la piste 16.

Il est bien entendu que la présente invention n'a été décrite et représentée qu'à titre d'exemple préférentiel et que l'on pourra remplacer ses éléments constitutifs par des éléments équivalents sans, pour autant sortir du cadre de l'invention.

Ainsi l'oscillateur tel que représenté dans son ensemble aux figures 3 et 4, aurait tout aussi bien pu être basé sur la réalisation représentée en figure 1.

## Revendications

1. Oscillateur à résonateur diélectrique et accord électronique de fréquence par varactor, notamment dans la gamme des 22 GHz, comprenant un élément électronique actif à résistance négative (17), au moins deux résonateurs diélectriques (40, 41), un substrat (13) à la surface duquel sont disposés trois pistes microruban (10, 11, 12), à la première (10) et à la seconde (11) pistes, qui sont situées dans le prolongement l'une de l'autre étant connectées respectivement deux électrodes de l'élément actif (17), caractérisé en ce qu'à la troisième piste (12), de direction parallèle aux deux premières (10, 11), est connecté le varactor (26), tous les résonateurs diélectriques (40, 42) étant couplés à la première piste microruban (10).

2. Oscillateur selon la revendication 1, caractérisé en ce que l'élément électronique actif à résistance négative est réalisée à l'aide d'un un transistor FET, la première piste microruban (10) étant reliée à la grille de ce transistor, la seconde piste (11) étant reliée au drain de ce transistor.

3. Oscillateur selon la revendication 2, caractérisé en ce que la première (10) et la troisième (12) pistes ont une première extrémité couplée respectivement à deux charges 50 $\Omega$ (14 et 15), la seconde ayant une première extrémité couplée à une quatrième ligne (16) reliée à une fiche de sortie hyperfréquence, le transistor ayant deux de ses électrodes grille et drain reliées respectivement aux secondes extrémités de la première (10) et de la seconde ligne (11), et ses autres électrodes soudées sur un petit support (18) situé dans une ouverture (19) réalisée dans le substrat.

4. Oscillateur selon la revendication 3, caractérisé en ce que trois circuits de polarisation chacun formé d'une ligne basse impédance (28, 29, 30) en quart de cercle et d'une ligne forte impédance (31, 32, 33), permettent respectivement de réaliser.

- la polarisation de grille ;
- la polarisation de drain ;
- la polarisation du varactor.

**5.** Oscillateur selon l'une quelconque des revendications précédentes, caractérisé en ce que deux résonateurs diélectriques (40, 41) sont respectivement situés de part et d'autre de la première piste microruban (10).

**6.** Oscillateur selon l'une quelconque des revendications 1 à 4, caractérisé en ce que trois résonateurs diélectriques (42, 43, 44) sont disposés entre la première (10) et la troisième (12) piste microruban.

**7.** Oscillateur selon l'une quelconque des revendications précédentes, caractérisé en ce qu'il comprend un boîtier (45), sur lequel vient se souder le substrat, le transistor étant soudé sur un support (18) luimême soudé sur la masse même du boîtier (45), la polarisation du transistor s'effectuant à travers des traversées étanches de grille (46) et de drain (47), la troisième ligne microruban (12), sur laquelle est fixée un varactor (26) étant couplée à la piste de grille, grâce à au moins un résonateur diélectrique (42, 43, 44).

**8.** Oscillateur selon la revendication 7, caractérisé en ce qu'au dessus du boîtier (45) se trouve un couvercle (51), dans lequel se trouve un trou taraudé (52), qui constitue une cheminée (53), dans lequel vient se visser une vis à double filetage (54), à l'intérieur de laquelle est disposée une vis autoserrante et adjustable (55), la vis (54) à double filetage étant bloquée à l'aide d'un écrou de blocage (56).

**9.** Oscillateur selon la revendication 8, caractérisé en ce qu'un capot (57) est solidarisé au boîtier (45) de manière à réaliser l'étanchéité de l'ensemble.

**10.** Oscillateur selon l'une quelconque des revendications précédentes, caractérisé en ce que le boîtier (45) et son couvercle (51) sont en DILVER, et le substrat (13) en quartz.

**11.** Oscillateur selon la revendication 7, caractérisé en ce que le support (18) du transistor (17) est en cuivre.

**12.** Oscillateur selon l'une quelconque des revendications précédentes, caractérisé en ce que le transistor (17) est un transistor FET AsGa.

## Claims

**1.** An oscillator having a dielectric resonator and being electronically tuned in frequency by a varactor, in particular in the 22 GHz range, the oscillator comprising an active electronic component having negative resistance (17), at least two dielectric resonators (40, 41), and a substrate (13) on the surface of which there are three microstrip tracks (10, 11, 12), two electrodes of the active component (17) being connected respectively to the first track (10) and the second track (11), which are aligned in succession, characterized in that the varactor (26) is connected to the third track (12), which runs parallel to the first two ones (10, 11), all of the dielectric resonators (40, 41) being coupled to the first microstrip track (10).

**2.** An oscillator according to claim 1, characterized in that the active electronic component having negative resistance is implemented by means of a field effect transistor, with the first microstrip track (10) being connected to the gate of this transistor and the second track (11) being connected to the drain of this transistor.

**3.** An oscillator according to claim 2, characterized in that each of the first and third tracks has a first end coupled to a respective 50-ohm load (14 or 15), the second track having a first end coupled to a fourth line (16) connected to a microwave output pin, the transistor having two of its electrodes, namely its gate and its drain, connected to respective second ends of the first and second microstrip lines (10, 11), and having its other electrodes welded to a small support (18) situated in an opening (19) provided in the substrate.

**4.** An oscillator according to claim 3, characterized in that three bias circuits each constituted by a quarter circle low impedance line (28, 29, 30) and a high impedance line (31, 32, 33) serve respectively:

- to bias the gate;
- to bias the drain; and
- to bias the varactor.

**5.** An oscillator according to any preceding claim, characterized in that two dielectric resonators (40, 41) are disposed on either side of the first microstrip track (10).

6. An oscillator according to any of claims 1 to 4, characterized in that three dielectric resonators (42, 43, 44) are disposed between the first microstrip track and the third strip track (10 and 12).

7. An oscillator according to any preceding claim, characterized in that it includes a housing (45) having the substrate welded thereon, with the transistor being welded to a support (18) which is itself welded to the ground of the housing (45), with the transistor being biassed via sealed gate and drain feedthroughs (46, 47), and with the third microstrip line (12) to which a varactor (26) is fixed being coupled to the gate microstrip line via at least one dielectric resonator (42, 43, 44).

8. An oscillator according to claim 7, characterized in that a lid (51) is provided over the housing (45), said lid including a chimney (53) consisting of a threaded hole (52) receiving a double-threaded screw (54), with a self-locking and adjustable screw (55) being received in the double-threaded screw, the double-threaded screw (54) being locked by means of a lock nut (56).

9. An oscillator according to claim 8, characterized in that a cover (57) is fixed to the housing (45) so as to provide a sealed assembly.

10. An oscillator according to any preceding claim, characterized in that the housing (45) and its lid (51) are made of DILVER and in that the substrate (13) is made of quartz.

11. An oscillator according to claim 7, characterized in that the support (18) of the transistor (17) is made of copper.

12. An oscillator according to any preceding claim, characterized in that the transistor (17) is a GaAs FET.

**Patentansprüche**

1. Oszillator mit dielektrischem Resonator und mit elektronischer Frequenzabstimmung durch Varaktor, insbesondere für den 22 GHz-Bereich, wobei der Oszillator ein aktives elektronisches Element (17) mit negativem Widerstand, mindestens zwei dielektrische Resonatoren (40, 41) und ein Substrat (13) aufweist, auf dessen Oberfläche drei Mikrostreifenbahnen (10, 11, 12) aufgebracht sind, und wobei an die erste (10) und die zweite Bahn (11), die in Verlängerung hintereinander angeordnet sind, jeweils eine Elektrode des aktiven Elements (17) angeschlossen ist, dadurch gekennzeichnet, daß die dritte Bahn (12), die parallel zu den beiden ersten (10, 11) verläuft, mit dem Varaktor (26) verbunden ist und daß alle dielektrischen Resonatoren (40, 41) an die erste Mikrostreifenbahn (10) angekoppelt sind.

2. Oszillator nach Anspruch 1, dadurch gekennzeichnet, daß das aktive elektronische Element mit negativem Widerstand aus einem Feldeffekttransistors (FET) besteht, wobei die erste Mikrostreifenbahn (10) mit dem Gate dieses Transistors und die zweite Bahn (11) mit dem Drain dieses Transistors verbunden ist.

3. Oszillator nach Anspruch 2, dadurch gekennzeichnet, daß die erste (10) und die dritte Bahn (12) mit einem ersten Ende jeweils an eine Last von 50 Ohm (14 und 15) angeschlossen sind, während die zweite Bahn mit einem ersten Ende an einen vierten Streifen (16) angekoppelt ist, der mit einem Mikrowellenausgangsanschluß verbunden ist, wobei der Transistor mit zwein seiner Elektroden, Gate und Drain, an das zweite Ende des ersten (10) bzw. des zweiten Streifens (11) angeschlossen ist, während seine anderen Elektroden an einen kleinen Träger (18) angeschweißt sind, der sich in einer im Substrat angebrachten Öffnung (19) befindet.

4. Oszillator nach Anspruch 3, dadurch gekennzeichnet, daß drei Vorspannkreise, jeweils bestehend aus einer Viertelkreisleitung (28, 29, 30) niedriger Impedanz und einer Leitung (31, 32, 33) hoher Impedanz, es ermöglichen,
   - die Vorspannung des Gates,
   - die Vorspannung des Drains, und
   - die Vorspannung des Varaktors zu realisieren.

5. Oszillator nach einem beliebigen der vorhergehenden Ansprüche, dadurch gekennzeichnet, daß zu beiden Seiten der ersten Mikrostreifenbahn (10) jeweils ein dielektrischer Resonator (40, 41) angeordnet ist.

6. Oszillator nach einem beliebigen der Ansprüche 1 bis 4, dadurch gekennzeichnet, daß drei dielektrische Resonatoren (42, 43, 44) zwischen der ersten (10) und der dritten Mikrostreifenbahn (12) angeordnet sind.

7. Oszillator nach einem beliebigen der vorhergehenden Ansprüche, dadurch gekennzeichnet, daß er ein Gehäuse (45) aufweist, auf dem das Substrat angeschweißt ist, wobei der Transistor auf einem Träger (18) aufgeschweißt ist, der seinerseits an die Masse des Gehäuses (45) angeschweißt ist, wobei das Vorspannen des Transistors durch dichte Durchführungen (46, 47) des Gates und des Drains erfolgt, während die dritte Mikrostreifenbahn (12), auf der ein Varaktor (26) befestigt ist, mit der Bahn des Gates über mindestens einen dielektrischen Resonator (42, 43, 44) gekoppelt ist.

8. Oszillator nach Anspruch 7, dadurch gekennzeichnet, daß sich über dem Gehäuse ein Deckel (51) befindet, in welchem ein Gewindeloch (52) angebracht ist, das einen Kamin (53) bildet, in den eine Schraube (54) mit Innen- und Außengewinde eingeschraubt ist, wobei im Inneren der Schraube eine selbsthemmende und einstellbare Schraube (55) angeordnet ist und die Schraube (54) mit den zwei Gewinden durch eine Blockiermutter (56) arretiert ist.

9. Oszillator nach Anspruch 8, dadurch gekennzeichnet, daß eine Kappe (57) mit dem Gehäuse (45) fest verbunden ist, derart, daß die Dichtheit des Ganzen bewirkt wird.

10. Oszillator nach einem beliebigen der vorhergehenden Ansprüche, dadurch gekennzeichnet, daß das Gehäuse (45) und sein Deckel (51) aus DILVER und das Substrat (13) aus Quarz bestehen.

11. Oszillator nach Anspruch 7, dadurch gekennzeichnet, daß der Träger (18) des Transistors (17) aus Kupfer besteht.

12. Oszillator nach einem beliebigen der vorhergehenden Ansprüche, dadurch gekennzeichnet, daß der Transistor (17) ein AsGa-Feldeffekttransistor ist.

# FIG.3

# FIG.4